# EUROPEAN PATENT APPLICATION

(11) **EP 4 723 862 A1**
(43) Date of publication of application: **08.04.2026**
(21) Application number: 25204347.6
(22) Date of filing: 24.09.2025
(51) Int. Cl.: H10W 40/47, H10W 40/00, H10W 40/73

(54) **COOLING FLUID FLOW PATHS USING KNIFE EDGE SEALS**

(30) Priority: 02.10.2024 US 202418904886; 10.09.2025 US 202519325388
(71) Applicant: HRL Laboratories, LLC, Malibu, CA 90265 (US)
(72) Inventor: ROPER, Christopher S., Malibu (US); SODHI, Avantika, Malibu (US); AUTRY, Travis M., Malibu (US); BREWER, Peter D., Malibu (US); HUANG, Lian X., Malibu (US); BUTTON, Mitchel A., Malibu (US); CARLSON, John A., Malibu (US)
(74) Representative: Lusinchi, Laurent Pierre

(57) **Abstract**

An electronic assembly including: a circuit substrate comprising an integrated circuit and having a first surface; and a heat removal substrate comprising a fluid path arranged for circulating a flow of cooling fluid between a fluid input and a fluid output, the heat removal substrate having a second surface attached to the first surface, wherein the fluid path includes a cavity having cavity walls, wherein a first portion of the cavity walls comprises a first portion of the first surface and a second portion of the cavity walls comprises a first portion of the second surface; and wherein the second surface is attached to the first surface by a cold weld compression seal that sealingly attaches the first portion of the first surface to the first portion of the second surface along a closed boundary; said compression seal along that closed boundary forming a third portion of the cavity walls..

## Description

### RELATED APPLICATIONS

. This presentation relates to U.S. application No. 18/904886, filed on October 2, 2024, as well as to US application No. 19/325,388, filed on September 10, 2025, the disclosures of which are hereby incorporated by reference in their entirety.

### TECHNICAL FIELD

. This presentation relates to electronic assemblies comprising a circuit substrate with integrated circuits that produce heat in operation, and comprising a heat removal substrate that uses a fluid path to circulate a flow of cooling fluid for removing the heat produced in the circuit substrate.

### BACKGROUND

. It is known that electronic circuits generate heat in operation, and that if the heat accumulates the operation of the circuits can be impaired and the circuits can be damaged. It has long been sought to remove the heat produced by the operation of electronic circuits. Fluid paths are commonly coupled thermally to an electronic circuit that produces heat, the fluid path being provided for circulating a flow of cooling fluid that removes the heat produced in the circuit substrate and brings the heat to for example a radiator system, where the heat is removed from the cooling fluid.

. However, when dealing with integrated electronic circuits, and more generally with any electronic circuit of the same order of size, it becomes challenging to manufacture fluid paths close to the transistor junctions and with few thermal interfaces, which is desirable to maximize the heat removed for a given temperature budget. It is also preferred to manufacture a plurality of narrow fluid paths rather than a single larger fluid path to maximize heat transfer rates. It has been attempted to manufacture fluid paths using the etching techniques devised for manufacturing integrated electronic circuits, but manufacturing the fluid path integrally in a same substrate as the circuit is technically difficult. It has also been attempted to manufacture different parts of the fluid path each on different substrate portions, then assemble the substrate portions for form a complete fluid path. However, this manufacturing process creates issues due to the available assembling processes.

. Assembling processes that use adhesives require a separate adhesive handling operation because adhesive use is not a standard microfabrication unit operation in integrated circuit fabrication. Furthermore, adhesive seals can leak, may have limited maximum operating temperature, and can dissolve in some coolants (especially 2-phase coolants) over time, which can lead to clogging of a microfluidic system. Some known current approaches to fluid path cooling use gaskets or adhesives that do not have sufficient reliability for long term operation.

. Assembling processes that use soldering create problems because these processes require a complex solder melting temperature ladder as several bonding steps are generally needed. Known solder melting temperature ladders require Pb-based solders, which are being phased out by law. Further, there is overall an industry desire to integrate more circuits in a package, which will require more bonding steps than there are solder temperature rungs. Also, material cracks may appear because of thermal coefficient mismatches.

. There remains a need for robust fluid paths that are close to integrated circuits, which can be manufactured easily and reliably.

### SUMMARY

. Embodiments of this presentation comprise fluid paths formed by manufacturing separately sub-portions of the fluid paths on different sub-substrates then assembling the sub-substrates using a cold-weld compression seal to fluidly seal together the sub-portions of the fluid path. At this juncture, it has to be pointed out that the term "cold-weld compression seal" as used in the present application is directed at compression bonds that can be formed at room temperature but also with some added heat, as long as the temperatures are lower than for example the temperatures needed to form a thermocompression bond (typically 200 Celsius and above). According to embodiments of this presentation, some sub-portions of the fluid path can comprise a microfluidic jet impingement structure. According to embodiments of this presentation, some sub-portions of the fluid path can comprise a microchannel structure.

. According to embodiments of this presentation, the substrate that carries the heat-producing integrated circuit can itself be one of said sub-substrates and comprise a sub-portion of the fluid path. This allows lowering the thermal resistance between the heat-producing integrated circuit and the fluid path.

. According to embodiments of this presentation, the fluid path can have a fluid input and a fluid output, both provided for being coupled to a fluid pump that circulates the fluid flow through the fluid path.

. According to embodiments of this presentation, the fluid path can form a closed loop which includes a thermosiphon or a heat pipe arranged to circulate the fluid flow through the fluid path.

. Embodiments of this presentation include a microelectronic assembly or package with a microfluidic cooling system, comprising at least one microelectronic chip or chiplet with active transistors, a chip with a jet impinging manifold, and at least one metal knife edge seal fluidly connecting the chip with a jet impinging manifold to the microelectronic chip or chiplet, the seal containing a cooling region of the microelectronic chip or chiplet.

. Embodiments of this presentation include a microelectronic assembly or package with a microfluidic cooling system, comprising at least one microelectronic chip or chiplet with active transistors and a microchannel cooling region, a chip with a manifold, and at least one metal knife edge seal fluidly connecting the chip with the manifold to the microelectronic chip or chiplet with the microchannel cooling region, the seal fluidly coupling the manifold to the microchannel cooling region.

. Embodiments of this presentation include an electronic assembly comprising: a circuit substrate comprising an integrated circuit, the circuit substrate having a first surface; and a heat removal substrate comprising a fluid path arranged for circulating a flow of cooling fluid between a fluid path input and a fluid path output, the heat removal substrate having a second surface attached to the first surface, wherein the fluid path includes a first cavity having cavity walls, wherein a first portion of the cavity walls comprises a first portion of the first surface and a second portion of the cavity walls comprises a first portion of the second surface; and wherein the second surface is attached to the first surface by at least a first cold weld compression seal that sealingly attaches the first portion of the first surface to the first portion of the second surface along a first closed boundary; said compression seal along that first closed boundary forming a third portion of the cavity walls.

. According to embodiments of this presentation, the fluid path comprises a circuit substrate cavity, the circuit substrate cavity being in the circuit substrate and having at least one circuit substrate cavity input and at least one circuit substrate cavity output, where the at least one circuit substrate cavity input comprises a first fluid path opening in said first portion of the first surface within said first closed boundary.

. According to embodiments of this presentation, the fluid path is partially filled with a liquid and is arranged to operate as an oscillating heat pipe when heat is generated by the integrated circuit.

. According to embodiments of this presentation, the heat removal substrate comprises a first heat removal substrate layer assembled to a second heat removal substrate layer by a second cold weld compression seal; said fluid path comprising a second cavity having a first portion of the second cavity in the first heat removal substrate layer and having a second portion of the second cavity in the second heat removal substrate layer; the first portion of the second cavity being sealed in fluid communication with the second portion of the second cavity by the second cold weld compression seal.

. According to embodiments of this presentation, the fluid path comprises a colder fluid chamber; the colder fluid chamber being separated from the first cavity by at least one jet opening; wherein said at least one jet opening is arranged for constricting the flow of cooling fluid between the colder fluid chamber and the first cavity.

. According to embodiments of this presentation, the at least one jet opening comprises a plurality of jet openings having each an axis directed at a predetermined region of said first portion of the first surface, to controllably cool down said predetermined regions of said first portion of the first surface.

. According to embodiments of this presentation, each of said plurality of jet openings have an opening size that is a function of the amount of cooling down the jet opening is provided for.

. According to embodiments of this presentation, the colder fluid chamber is arranged to receive the flow of cooling fluid from the fluid path input and the fluid path is arranged such that the flow of cooling fluid entering the first cavity by the at least one jet opening exits from the first cavity toward the fluid path output.

. According to embodiments of this presentation, the fluid path input and output are respectively provided for being connected to an external fluid circuit.

. According to embodiments of this presentation, the fluid path comprises a colder fluid chamber fluidly connected to the first cavity upstream of said fluid path input; and a cooling chamber fluidly connected to the first cavity downstream of the fluid path output; the cooling chamber being in fluid communication with the further downstream colder fluid chamber; the cooling chamber being thermally coupled with a heat exchange structure; the first cavity, cooling chamber and colder fluid chamber being arranged such that: when said integrated circuit generates heat, the heat causes a portion of the cooling fluid, that has passed into the first cavity from the colder fluid chamber, to warm up and enter the cooling chamber where the fluid is cooled down by heat exchange with the heat exchange structure and the cooled fluid enters back the colder fluid chamber.

. According to embodiments of this presentation, the fluid path forms at least a portion of one of a thermosiphon or a heat pipe.

. According to embodiments of this presentation, the fluid path forms at least a portion of a heat pipe, and the fluid path has walls covered with a wicking material arranged to bring condensed fluid from a condensation cavity to a portion of the first cavity that receives heat produced by the integrated circuit.

. According to embodiments of this presentation, the circuit substrate additionally comprises a circuit substrate fluid output in fluid communication with the at least one circuit substrate cavity input and a circuit substrate fluid input in fluid communication with the at least one circuit substrate cavity output, the electronic assembly further comprising a circuit substrate stack having a stack fluid output and a stack fluid input; the stack fluid input being sealingly connected to the circuit substrate fluid output using a second cold weld compression seal and the stack fluid output being sealingly connected to the circuit substrate fluid input using a third cold weld compression seal; the circuit substrate stack comprising at least one additional circuit substrate having an additional integrated circuit, and being arranged such that fluid circulated in the fluid path captures heat produced by the additional integrated circuit.

. According to embodiments of this presentation, the circuit substrate comprises a first via electrically connected to a first electrical contact pad on a third surface, opposite the first surface, and the circuit substrate stack comprises a second via electrically connected to a second electrical contact pad on a fourth surface, facing the third surface; the first and second electrical contact pad being aligned and being electrically connected using a cold weld compression contact structure.

. According to embodiments of this presentation, the circuit substrate comprises a first via electrically connected to a first electrical contact pad on said first surface, and the heat removal substrate comprises a second via electrically connected to a second electrical contact pad on said second surface; the first and second electrical contact pad being aligned and being electrically connected using a cold weld compression contact structure.

. According to embodiments of this presentation, the first via is electrically connected to said integrated circuit and the second via is electrically connected to a third electrical contact pad on a top surface of the heat removal substrate.

. According to embodiments of this presentation, at least a portion of the circuit substrate cavity comprises microchannels that facilitate heat transfer between said cooling fluid and said circuit substrate, the microchannels having microchannel inputs and microchannel outputs wherein the microchannel inputs are in fluid communication with the at least one circuit substrate cavity input through an input manifold, and the microchannel outputs being in fluid communication with the at least one circuit substrate cavity output through an output manifold.

. According to embodiments of this presentation, the input manifold forms part of the circuit substrate cavity and is in fluid communication with the first cavity and the output manifold is in fluid communication with the fluid path output through an exhaust cavity; wherein the exhaust cavity is sealingly connected to said at least one circuit substrate cavity output using a second cold weld compression seal formed along a second closed boundary.

. According to embodiments of this presentation, the circuit substrate comprises a first circuit substrate layer attached to a second circuit substrate layer; wherein the first circuit substrate layer comprises said integrated circuit, said microchannels, said microchannel inputs and said microchannel outputs; and wherein the second circuit substrate layer comprises said at least one circuit substrate cavity input, said input manifold, said at least one circuit substrate cavity output and said output manifold; the first circuit substrate layer being attached to a second circuit substrate layer by a third cold weld compression seal sealingly coupling said microchannel inputs to said input manifold and by a fourth cold weld compression seal sealingly coupling said microchannel outputs to said output manifold.

. According to embodiments of this presentation, the cold weld compression seal comprises a knife-edge wall of a harder material having a foot attached to one of the first and second surfaces along said first closed boundary, said knife-edge wall being coated with a softer metal before being pressed on a seal strip of another softer metal attached to the other of the first and second surfaces along said first closed boundary.

. According to embodiments of this presentation, the harder metal is titanium and the softer metals are selected from gold, copper, indium or aluminum.

. According to embodiments of this presentation, the materials of the circuit and heat removal substrates are selected among Si, SiC, GaAs, GaN, SiGe.

. According to embodiments of this presentation, the circuit substrate comprising an integrated circuit includes a first sub-substrate comprising a first integrated circuit portion and includes a second sub-substrate comprising the circuit substrate cavity, wherein the first sub-substrate has a first sub-surface attached to a second sub-surface of the second sub-substrate.

### FIGURES

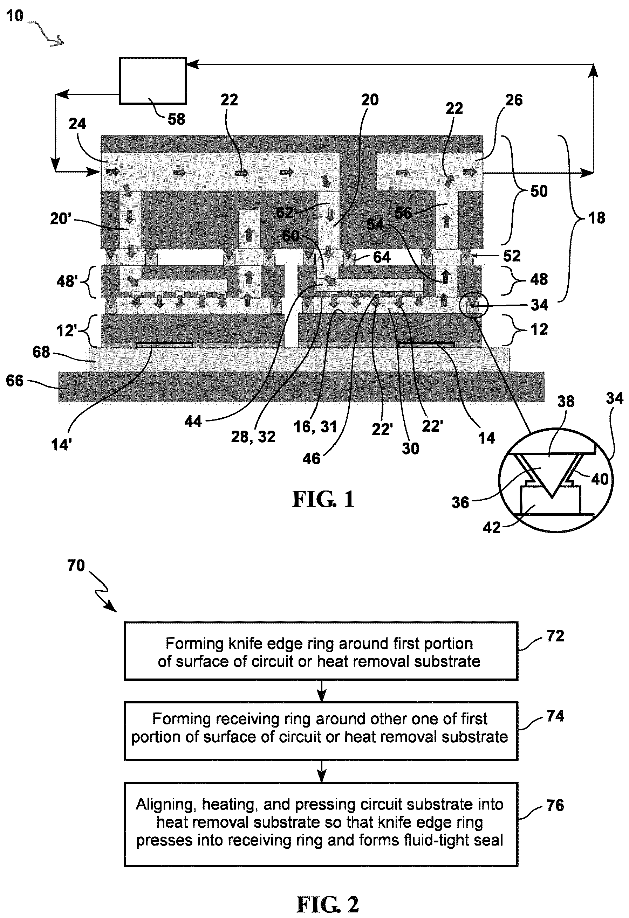

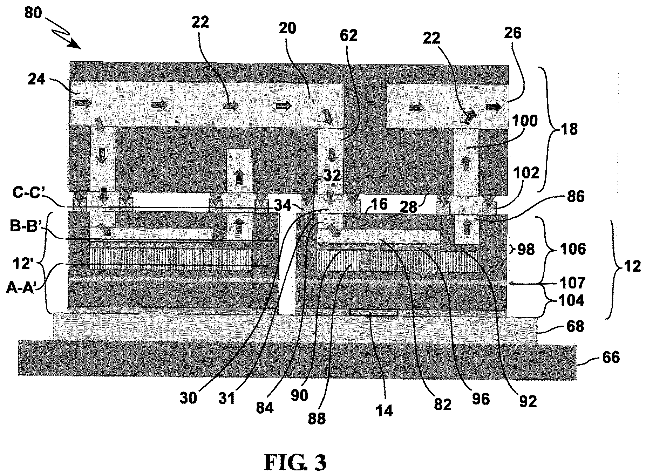

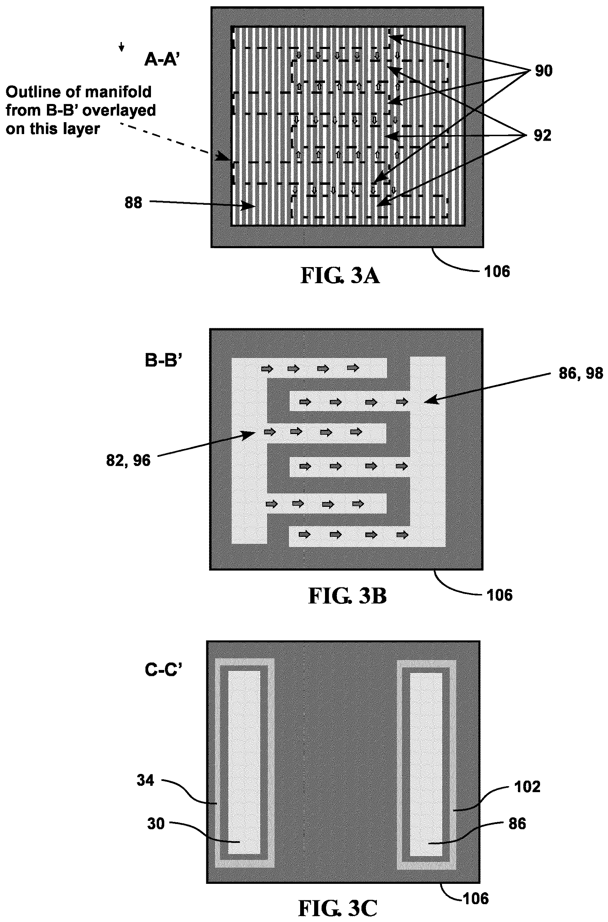

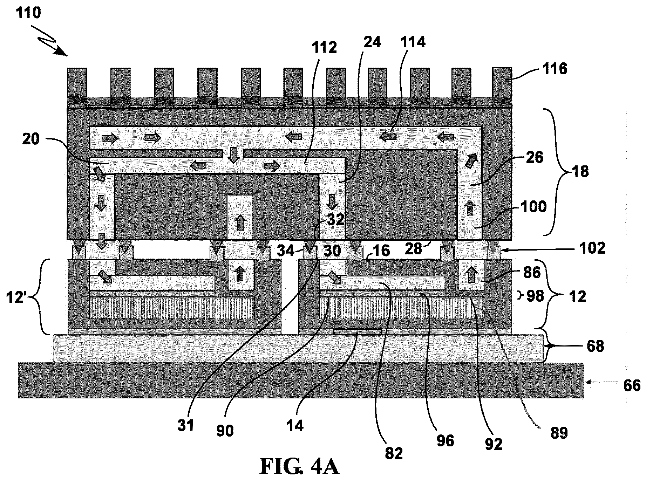

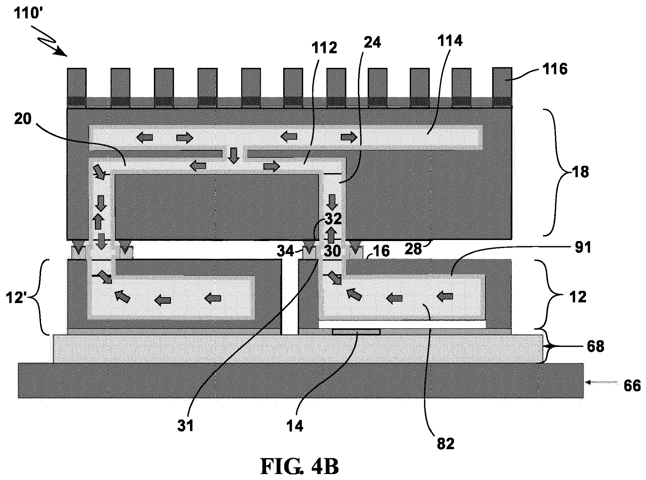

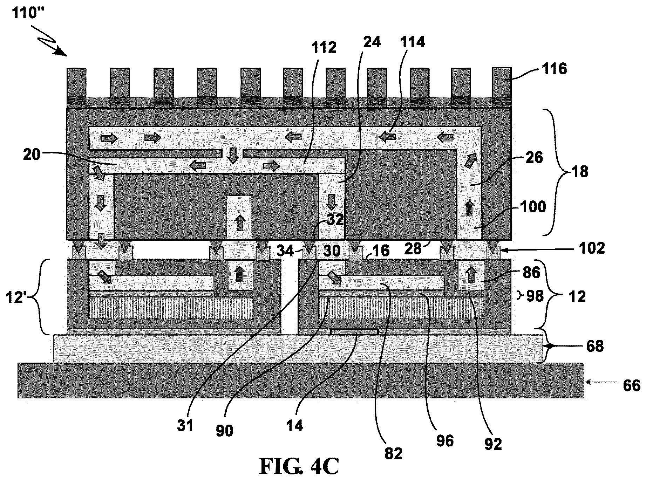

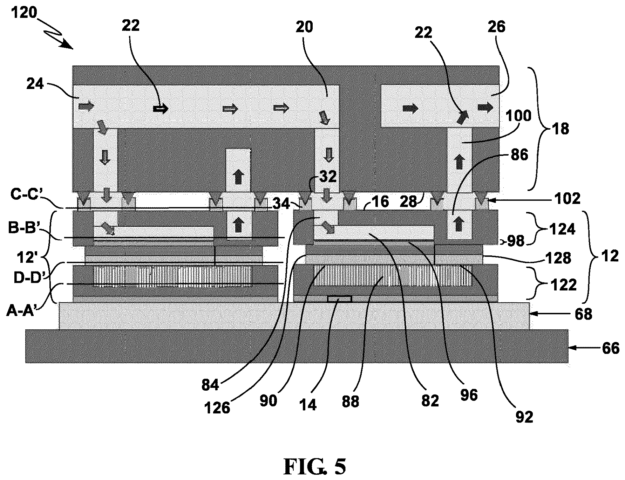

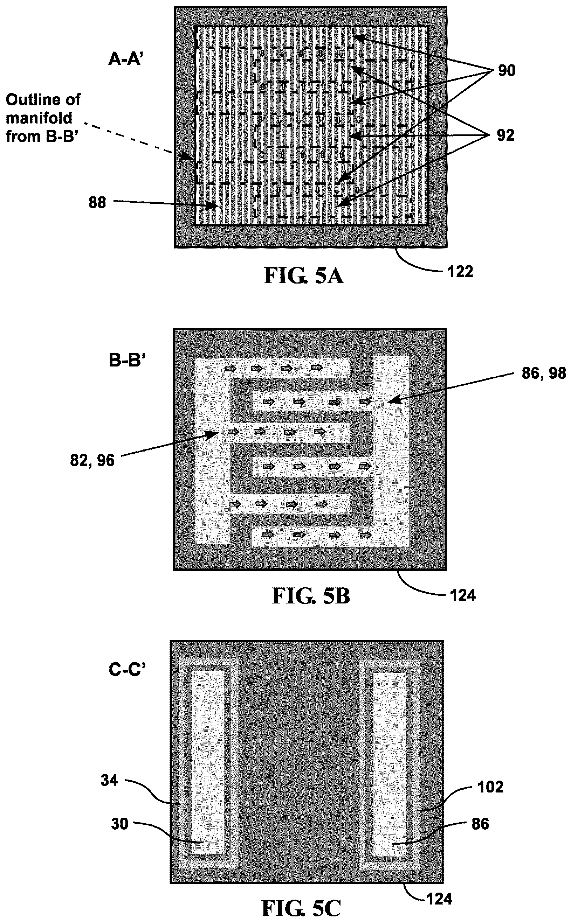

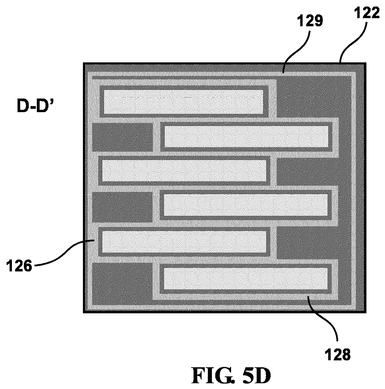

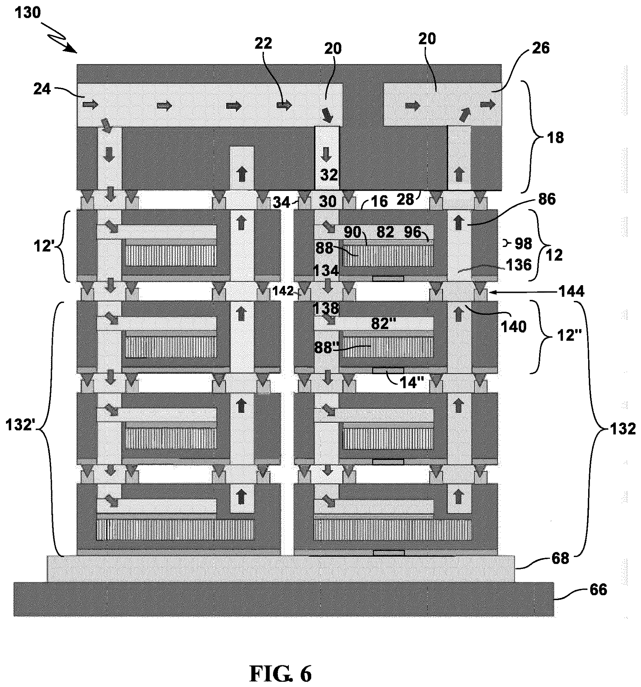

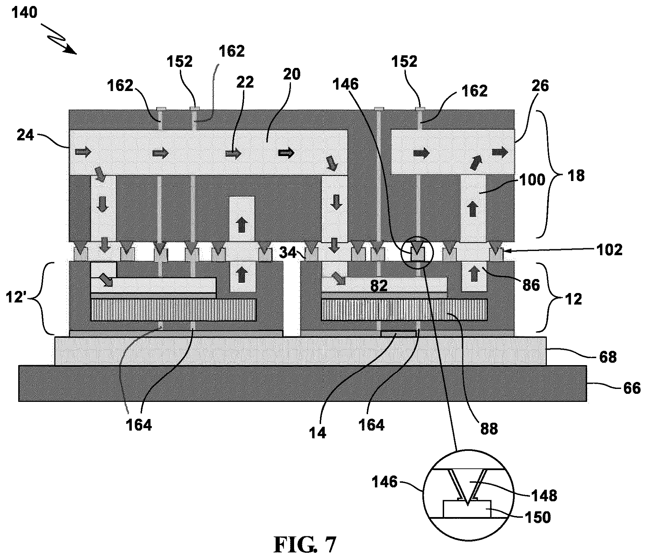

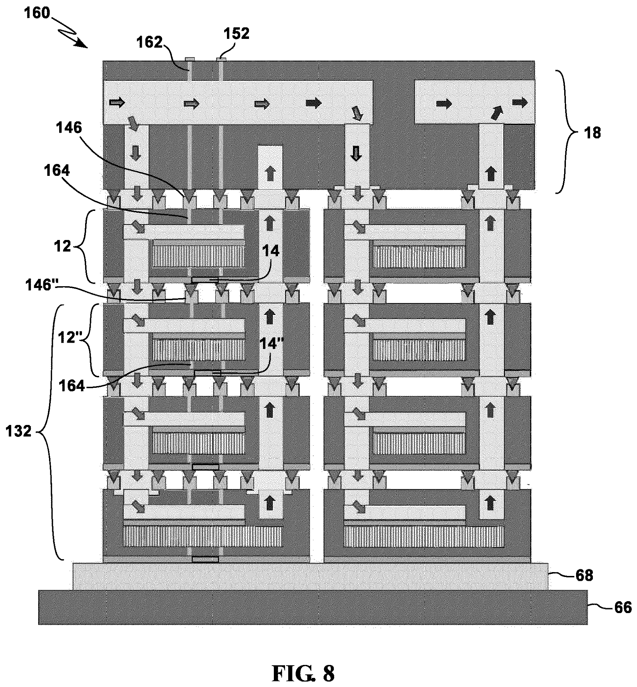

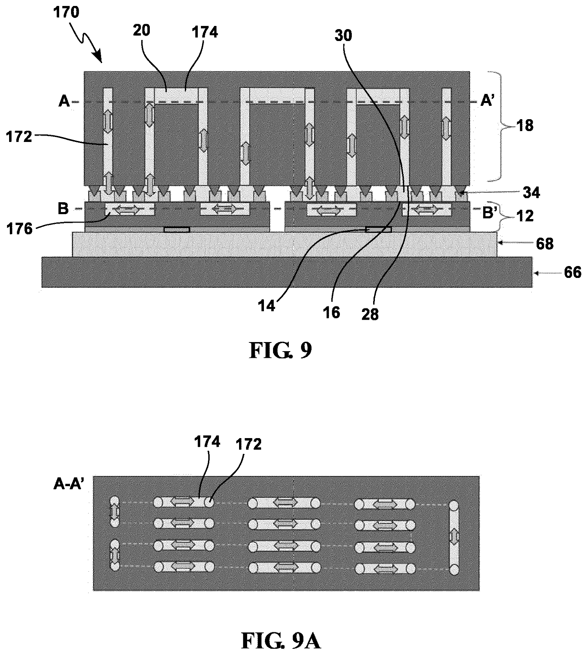

. The above features will now be described in more details in relation with the following figures, wherein:
. Figure 1 illustrates a cross section along a vertical plane of an electronic assembly according to embodiments of this presentation.
. Figure 2 illustrates a method according to embodiments of this presentation.
. Figure 3 illustrates a cross section along a vertical plane of an electronic assembly according to embodiments of this presentation.
. Figure 3A illustrates a partial cross section along a horizontal plane A-A'of the electronic assembly shown in Figure 3.
. Figure 3B illustrates a partial cross section along a horizontal plane B-B'of the electronic assembly shown in Figure 3.
. Figure 3C illustrates a partial cross section along a horizontal plane C-C'of the electronic assembly shown in Figure 3.
. Figure 4A illustrates a cross section along a vertical plane of an electronic assembly according to embodiments of this presentation.
. Figure 4B illustrates a cross section along a vertical plane of an electronic assembly according to embodiments of this presentation.
. Figure 4C illustrates a cross section along a vertical plane of an electronic assembly according to embodiments of this presentation.
. Figure 5 illustrates a cross section along a vertical plane of an electronic assembly according to embodiments of this presentation.
. Figure 5A illustrates a partial cross section along a horizontal plane A-A'of the electronic assembly shown in Figure 5.
. Figure 5B illustrates a partial cross section along a horizontal plane B-B'of the electronic assembly shown in Figure 5.
. Figure 5C illustrates a partial cross section along a horizontal plane C-C'of the electronic assembly shown in Figure 5.
. Figure 5D illustrates a partial cross section along a horizontal plane D-D'of the electronic assembly shown in Figure 5.
. Figure 6 illustrates a cross section along a vertical plane of an electronic assembly according to embodiments of this presentation.
. Figure 7 illustrates a cross section along a vertical plane of an electronic assembly according to embodiments of this presentation.
. Figure 8 illustrates a cross section along a vertical plane of an electronic assembly according to embodiments of this presentation.
. Figure 9 illustrates a cross section along a vertical plane of an electronic assembly according to embodiments of this presentation.
. Figure 9A illustrates a partial cross section along a horizontal plane A-A'of the electronic assembly shown in Figure 9.

### DETAILED DESCRIPTION

. The following description is presented to enable one of ordinary skill in the art to make and use the teachings of this presentation and to incorporate them in the context of particular applications. Various modifications, as well as a variety of uses in different applications will be readily apparent to those skilled in the art, and the general principles defined herein may be applied to a wide range of embodiments. Thus, the present invention is not intended to be limited to the embodiments presented, but is to be accorded the widest scope consistent with the principles and novel features disclosed herein.

. In the following detailed description, numerous specific details are set forth in order to provide a more thorough understanding of embodiments of this presentation. However, it will be apparent to one skilled in the art that such embodiments may be practiced without necessarily being limited to these specific details.

. All the features disclosed in this presentation, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

. Furthermore, any element in a claim that does not explicitly state "means for" performing a specified function, or "step for" performing a specific function, is not to be interpreted as a "means" or "step" clause as specified in 35 U.S.C. Section 112(f). In particular, the use of "step of' or "act of' in the claims herein is not intended to invoke the provisions of 35 U.S.C. 112, Paragraph 6 (Pre-AlA).

. Figure 1 illustrates an electronic assembly 10 according to embodiments of this presentation, which comprises a "chip" or circuit substrate 12 in which an integrated circuit 14 is formed. The circuit substrate 12 has a first surface 16. Assembly 10 also comprises a heat removal substrate 18 in which is formed a fluid path 20 arranged for circulating a flow 22 of cooling fluid, between a fluid path input 24 and a fluid path output 26. In Fig. 1, the flow 22 is shown using series of short arrows. When a series of arrows in a cavity appears to terminate or originate in a dead-end, this indicates that said cavity connects to other cavities that are not in the same plane as the cross-section plane illustrated in Fig. 1. The heat removal substrate 18 has a second surface 28 attached to the first surface 16. The fluid path 20 includes a first cavity 30 having cavity walls, wherein a first portion of the cavity walls comprises a first portion 31 of the first surface 16 and a second portion of the cavity walls comprises a first portion 32 of the second surface 28. According to this presentation, the second surface 28 is attached to the first surface 16 by at least a first cold weld compression seal 34 that sealingly attaches the first portion 31 of the first surface 16 to the first portion 32 of the second surface 28 along a first closed boundary. Said compression seal 34 along that first closed boundary forms a third portion of the cavity walls and essentially completes first cavity 30.

. An enlarged cross section of cold weld compression seal 34 is illustrated in Figure 1. According to embodiments of this presentation, the cold weld compression seal 34 comprises a knife-edge wall 36 (i.e. for example having a triangular cross-section) of a harder material, for example a harder metal having a foot 38 attached to one of the first (16) and second (28) surfaces, said knife-edge wall 36 being coated with an overlay metal layer 40 of a softer metal before being pressed on a seal strip layer 42 of another softer metal attached to the other of the first (16) and second (28) surfaces along said closed boundary. The cold weld compression seal 34 is for example as the seal described in detail in U.S. application No. 18/904886, entitled "High-vacuum Micro-Vacuum cells" and filed on October 2, 2024, the disclosure of which is hereby incorporated by reference in its entirety. The cold weld compression seal 34 can be formed using a plastic-deformation based thermocompression bond or a thermos-compression bond. It is to be noted that a "peeling back" of the overlay metal layer (40) during the penetration into the seal strip layer (42), as illustrated in Figure 1, does not happen in all cases. The peeling back happens when the overlay metal layer (40) is softer or the same hardness as the seal strip layer (42). For example, when the metal comprising knife-edge wall 36 is Ti and the overlay metal layer (40) is Au and the seal strip layer (42) is Au, the overlayer metal layer (40) will peel back as shown in Figure 1. This allows the core metal (36) to bond with the seal strip layer (42). On the other hand if the overlay metal layer (40) is harder than the seal strip layer (42), for example if the overlayer metal layer (40) is Pt and the seal strip layer is Au (42) then the overlay metal does not deform and stays intact without peeling during the penetration.

. Other details about the cold-weld compression seal can be found in:
. U.S. patent No. 12,057,429 B1, entitled "Temporary Bonding Structures for Die-to-Die and Wafer-to-Wafer Bonding" to A. Lopez, P. Brewer, P. Naghibi-Mahmoudabdi, E. Daniel, T. Hussain, the disclosure of which is hereby incorporated by reference in its entirety.
. U.S. patent No. 11,555,830 B2 entitled "Small Pitch Integrated Knife Edge Temporary Bonding Microstructures", to E. Daniel, A. Lopez, P. Brewer, the disclosure of which is hereby incorporated by reference in its entirety.
. U.S. Patent No. 11, 562, 984 B1, entitled "Integrated Mechanical Aids for High Accuracy Alignable-Electric Contacts", to P. Brewer, A. Lopez, P. Naghibi-Mahmoudabdi, T. Hussain, the disclosure of which is hereby incorporated by reference in its entirety.

. According to embodiments of this presentation, the harder metal of knife-edge wall 36 is titanium and the softer metals of layers 40 and 42 are both gold. Alternatively, the softer metals of layers 40 and 42 can be made of copper, indium or aluminum. According to embodiments of this presentation, the materials of the first and second substrates can be Si, SiC, GaN, or SiGe, GaAs, InP, AlGaN, ZnSe, LiNbO3, Ge, Al2O3 / sapphire, LiTaO3, diamond, fused silica, the materials known under the name Borofloat^{®} glass or other glasses (BK7, B33, D263, gorilla glass, etc.), single crystal quartz, ZnO, silicon on insulator (SOI) or any other semiconductor substrate. The integrated circuit of the circuit substrate can comprise logic circuits, memory circuits, amplifier circuits, power-amplifier circuits, etc. The integrated circuit of the circuit substrate can include digital, analog, or mixed-signal circuits. The integrated circuit of the circuit substrate can have some optical functions (e.g. laser diode for emitting light, detector circuit for detecting light). The first portion 31 of the first surface 16 of the circuit substrate 12 can comprise etched or deposited structures (not shown in Figure 1) to enhance heat transfer between the circuit substrate and the cooling fluid in the fluid path 20.

. As also illustrated in Fig. 1, in embodiments of this presentation the fluid path 20 comprises a colder fluid chamber 44 upstream of the first cavity 30. The colder fluid chamber 44 can be separated from the first cavity 30 by at least one jet opening 46 arranged for constricting the flow 22 of cooling fluid and increasing the velocity of the flow 22 of cooling fluid entering the first cavity 30. The constriction due to the jet openings causes flow 22 to form a jetting flow that, when impinging on the first portion 31 of the first surface 16, generates an increased convective heat transfer coefficient between the first portion 31 of the first surface 16 and the cooling fluid of flow 22. As illustrated, the at least one jet opening 46 preferably comprises a plurality of jet openings 46 having each an axis directed at a predetermined region of the first portion 31 of the first surface 16. In Fig. 1, the axes of the jet openings 46 are all vertical, but the jet openings 46 can be manufactured with axes having different angles if desired. The jet openings 46 split flow 22 into multiple jets of fluid 22' that can be aimed at different predetermined regions of the first portion 31 of the first surface 16. This can be particularly advantageous if said predetermined regions generate more heat than other regions of the first portion 31 of the first surface 16, because it allows to controllably cool down said predetermined regions in priority. According to embodiments of this presentation, each of the jet openings 46 can also have an opening size that is a function of the amount of cooling the jet opening is provided for. Alternatively, a plurality of jet openings 46 can be arranged with their axes pointing at a same predetermined region of the first portion 31 of the first surface 16, which requires more cooling than other regions.

. According to embodiments of this presentation, the colder fluid chamber 44 is arranged to receive the flow 22 of cooling fluid from the fluid path input 24 and the fluid path 20 is arranged such that the flow 22 of cooling fluid entering the first cavity 30 by the at least one jet openings 46 is directed from the first cavity 30 toward the fluid path output 26. According to embodiments of this presentation, the fluid path input 24 and output 26 are respectively provided for being connected to an output and an input of a fluid pump 58. Fluid pump 58 can be powered by the same source of power as the circuit 14 in circuit substrate 12. It is to be noted that the external fluid loop that includes pump 58 includes means (not shown) to reject heat from the coolant after it leaves 26 and before it enters 24 (could be before or after the pump). Examples of such means include a liquid-air heat exchanger (HX), liquid-liquid-liquid HX, panel(s) for radiating away the heat, a phase change material for transiently storing heat, a condenser for condensing the coolant (if the coolant was partially or fully evaporated).

. As also illustrated in Fig. 1, according to embodiments of this presentation the heat removal substrate 18 can be made of a plurality of layers assembled together also by cold weld compression seals. In Fig. 1, the heat removal substrate 18 is made of a first heat removal substrate layer 48 attached to a second heat removal substrate layer 50 by a second cold weld compression seal 52, and the fluid path 20 comprises a second cavity, downstream of the first cavity, having a first portion 54 in the first heat removal substrate layer 48 and having a second portion 56 in the second heat removal substrate layer 50. The first portion 54 of the second cavity is sealed in fluid communication with the second portion 56 of the second cavity by the second cold weld compression seal 52, which follows a perimeter of openings of cavity portions 54, 56 into substrate layers 48, 50, respectively.

. As also illustrated in Fig. 1, the fluid path 20 can comprise a third cavity, upstream of the colder fluid chamber 44, having a first portion 60 in the first heat removal substrate layer 48 and having a second portion 62 in the second heat removal substrate layer 50. The first portion 60 of the second cavity is sealed in fluid communication with the second portion 62 of the second cavity by a third cold weld compression seal 64, which follows a perimeter of openings of cavity portions 60, 62 into substrate layers 48, 50, respectively, and also participates to attaching substrate layer 48 to substrate layer 50. Cold weld compression seals 52 and 64 have a same structure as cold weld compression seal 34, but may comprise different dimensions or materials.

. As also illustrated in Fig. 1, according to embodiments of this presentation a single second heat removal substrate layer 50 can be attached to a plurality of first heat removal substrate layers 48, 48' (two shown in Fig. 1). Because fluid path input 24 and fluid path output 26 are formed in substrate layer 50, substrate layer 50 can act as a manifold to direct the fluid flow 22 to an additional fluid path 20' formed in the additional substrate layer 48', where substrate layer 48' is itself attached to an additional circuit substrate 12' that carries an additional integrated circuit 14'. Circuit substrate 12' and substrate layer 48' can have similar structures and operation as circuit substrate 12 and substrate layer 48. Circuits 14 and 14' can have similar or different structures or operation. Circuits 14 and 14' can have different functions (compute vs. memory vs. sensing vs. input/output). Some circuits 14 and 14' may be analog circuits, and some may be digital circuits. Circuit substrate 12' and substrate layer 48' can have different thicknesses than circuit substrate 12 and substrate layer 48, as long as their combined thicknesses are identical. Each of the layers 12, 12', 48, 48', 50 can be manufactured using known photolithography processes (using etching and deposition and/or also possibly wafer bonding, for example fusion bonding). The largest layers such as layer 50 can be 3-D printed, machined or injection molded.

. According to embodiments of this presentation, the cooling fluid or coolant in fluid path 20 can be water, propylene glycol-water mixture, ethylene glycol-water mixture, oil, hydrocarbon, halocarbon, dielectric fluid, refrigerant, halohydrocarbon, etc... The fluid path 20 can be arranged to maintain the fluid essentially as a single phase fluid or it can be arranged to maintain the fluid as a two-phase fluid (in liquid state, vapor state, or a combination (bubbly flow, slug flow)) in various regions of the fluid path, for example if the fluid path forms a heat pipe or a thermosiphon (or pumped flow boiling) as detailed hereafter. Other examples include microchannel flow boiling or jet impingement with boiling. Overall, fluid path 20 comprises at least one heat exchanger structure to move the heat generated by the integrated circuit into the cooling fluid.

. According to embodiments of this presentation, the "chip" or circuit substrate 12 in which an integrated circuit 14 is formed can comprise a substrate 12 in which multiple microelectronic smaller chips, or chiplets, 14 with active transistors are embedded, for example using the technology described in US patent No. 10,998,273, entitled: "HYBRID INTEGRATED CIRCUIT ARCHITECTURE", which is incorporated by reference in its entirety.

. As illustrated in Fig. 1, circuit substrate 12 (as well as circuit substrate 12') can be attached to a substrate (e.g. a printed circuit board (PCB), or a Si substrate, a glass substrate, an organic substrate, etc.) 66, optionally using an interposer substrate 68 in between. Attachment can be made using an adhesive, or alternatively attachment can use a filled adhesive (E.g. with thermally conductive particles), a solder layer, a solder ball grid array, a solder capped pillar array, a thermocompression bond, a fusion bond, an oxide direct bond, a hybrid bond, etc...) Attachment may also include wire bonding and/or ribbon bonding for electrical connections.

. As outlined above, substrate layer 50 can operate as a manifold to distribute fluid to two smaller substrate layers 48, 48' (or more (e.g. at least 3, at least 4, at least 8, at least 20, at least 50, at least 100, just not depicted). Similarly, a larger substrate layer (not shown) could be attached by cold weld compression seals to a plurality of substrate layers such as substrate layer 50 and operate as a manifold to the latter.

. According to embodiments of this presentation, substrates 12 and 18 may have a thickness comprised between 1um and 1mm, preferably between 10um and 1mm. According to embodiments of this presentation, the fluid path can comprise channels or microchannels. Aa width of a microchannel can be comprised between 1um and 500um, preferably between 5um and 200um, most preferably between 5um and 50um. According to embodiments of this presentation a pitch between two consecutive microchannels (cross-section center to cross-section center) can be comprised between 1.2X and 10X the microchannel width, and preferably comprised between 1.5X and 3X. According to embodiments of this presentation, and aspect ratio of the microchannels (cross-section height / cross-section width) can be comprised between 1:1 and 100:1, more preferably between 2:1 and 20:1, most preferably between 4:1 and 12:1. According to embodiments of this presentation, substrates 12 and 18 may have an area comprised between 0.5 x 0.5 mm2 and 100x100mm2, more preferably between 1x1 mm2 and 50x50mm2. According to embodiments of this presentation, interposer substrate 68 may have an area comprised between 5x5 mm2 and 500x500 mm2; more preferably between 10x10 mm2 and 150x150mm2. According to embodiments of this presentation, a cross section of non-microchannel (i.e. channel) fluid paths in substrates 12, 18 can be comprised between 1um and 10mm; preferably between 80um and 500 um.

. A technical effect of the assembly detailed hereabove is to achieve a reduced thermal resistance between the integrated circuit 14 and the cooling fluid in fluid path 20. Known modern microelectronic systems, including CPUs, GPUs, GPU superchips (e.g. for AI), phased arrays for radar front ends, power electronics, memory, etc., are dissipating high power, often in small packages, with more internal interfaces (thus higher internal thermal resistances) than in the assemblies depicted in this presentation. The semiconductor transistor junction temperature of the integrated circuits must not exceed critical thresholds to not irreversibly damage the devices and systems or degrade performance. By reducing the thermal resistance to coolant, higher power chips and more tightly integrated chips (2.5D, 3D, 3.5D, etc) are enabled by assemblies according to this presentation.

. The micro-knife-edge seals (or cold weld compression seals) described in this disclosure enable low-bonding-temperature, leak-free microfluidic connections that can tolerate high subsequent processing temperature. This conveys at least two advantages: (1) leak-free connections can be made directly to active semiconductor chips at low processing temperatures, enabling direct liquid cooling attachment without exceeding the thermal budget of the semiconductor chip, and (2) leak-free connections can be made throughout a microelectronics package/assembly at low temperature, thus (a) minimizing thermomechanical stress and thereby preventing cracks and mechanical failure and (b) avoiding complex solder melting temperature ladders (thus allowing to increase the number of bonding steps, and thus chips, that can be integrated and providing flexibility in the order of assembly to open the design space and improve manufacturability). Embodiments of this presentation can be used to improve the thermal management of electronics assembly in the fields of communications, radar, electric vehicle power electronics, including on-board and off-board recharging, GPUs (e.g. for AI), CPUs, etc...

. Furthermore, embodiments of this presentation can enable direct cooling (no thermal interface material or solder) of a microelectronic chip without needing to etch or otherwise form microchannels in the back of the microelectronic chip. The elimination of thermal interfaces improves heat transport (reduces thermal resistance). Micro-knife edge seals solve the long standing problem of how to make a leak-tight seal from the jet impingement manifold to the microelectronic chip.

. Fig. 2 illustrates a method 70 according to embodiments of this disclosure for fabricating an assembly as shown in Fig. 1, the method including the steps of:

. Forming 72 a knife edge ring (knife edge wall 36, forming overlay metal layer 40) around a first portion 32 of second surface 28 of heat removal substrate layer 48. Then forming 74 a receiving ring (seal strip layer 42) around a first portion 31 of the first surface 16 of circuit substrate 12.

. Alternatively, step 72 may comprise forming a knife edge ring (knife edge wall 36, forming overlay metal layer 40) around a first portion 31 of the first surface 16 of circuit substrate 12. In this embodiment of the method 70, step 74 comprises forming a receiving ring (seal strip layer 42) around a first portion 32 of second surface 28 of heat removal substrate layer 48. It will be noted that the ring can have a circular shape or another shape, for example parallelepipedic.

. The Method further includes aligning, heating, and pressing 76 the circuit substrate 12 into heat removal substrate 14 so that the knife edge ring on the first substrate presses into the receiving ring of the second substrate, forming a fluid-tight seal (34).

. Figure 3 illustrates a cross section of an electronic assembly 80 according to embodiments of this presentation, which also has a circuit substrate 12 comprising an integrated circuit 14, the circuit substrate having a first surface 16; and a heat removal substrate 18 comprising a fluid path 20 arranged for circulating a flow 22 of cooling fluid between a fluid path input 24 and a fluid path output 26, the heat removal substrate having a second surface 28 attached to the first surface 16, wherein the fluid path includes a first cavity 30. A first portion of the cavity walls comprises a first portion 31 of the first surface 16 and a second portion of the cavity walls comprises a first portion 32 of the second surface 28; and the second surface 28 is attached to the first surface 16 by a first cold weld compression seal 34 that sealingly attaches the first portion 31 of the first surface 16 to the first portion 32 of the second surface 28 along a first closed boundary; said compression seal 34 along that first closed boundary forming a third portion of the cavity walls. According to embodiments of this presentation, the fluid path 20 of assembly 80 comprises a circuit substrate cavity 82 downstream of the first cavity 30, formed in circuit substrate 12 and having at least one circuit substrate cavity input 84 and at least one circuit substrate cavity output 86, where the at least one circuit substrate cavity input 84 opens in said first portion 31 of the first surface 16 within said first closed boundary.

. As illustrated in Fig. 3, according to embodiments of this presentation, at least a portion of the circuit substrate cavity 82 comprises microchannels 88 that facilitate heat transfer between the cooling fluid and circuit substrate 12. The microchannels 88 have microchannel inputs 90 and microchannel outputs 92, wherein the microchannel inputs 90 are in fluid communication with the circuit substrate cavity input 84 through an input manifold 96, and wherein the microchannel outputs 92 are in fluid communication with the at least one circuit substrate cavity output 86 through an output manifold 98. As illustrated in Fig. 3, input manifold 96 can form part of the circuit substrate cavity 82 and be in fluid communication with first cavity 30, and output manifold 98 can be in fluid communication with the fluid path output 26 through an exhaust cavity 100 in fluid communication with circuit substrate cavity output 86; wherein exhaust cavity 100 is sealingly connected to circuit substrate cavity output 86 using a second cold weld compression seal 102 formed along a second closed boundary. Cold weld compression seals 34 and 102 are provided for being formed at a same time by pressing substrates 18 and 12 together.

. As illustrated in Fig. 3, circuit substrate 12 can comprise a first circuit substrate layer 104, wherein the circuit 14 is formed, assembled to a second circuit substrate layer 106, wherein the circuit substrate cavity 82 is formed. Layer 104 can be a regular integrated circuit (IC) chip. Layer 104 can be attached to layer 106 using a thermal interface layer 107. Thermal interface layer 107 can be metal particle based (e.g. arctic silver); phase change material based; it can comprise thermal grease; it can be metal nanowire based; indium foil based; graphene based or carbon nanotube based. Thermal interface 107 can alternatively be an adhesive, a filled adhesive (e.g. with thermally conductive particles), a solder layer, a solder ball grid array, a solder capped pillar array, a thermocompression bond, a fusion bond, an oxide direct bond, a hybrid bond, etc.) a direct silicon bond, a direct copper bond, or another direct bond. Preferably, thermal interface 107 is a direct bond, thermocompression bond, or a soldered bond. Alternatively, as illustrated in Fig. 4, circuit substrate 12 can comprise a single layer wherein both circuit 14 and cavity 82 are formed.

. As for the embodiment illustrated in Figure 1, heat removal substrate 18 can be attached to a plurality of circuit substrates 12, 12', for example attached to a PCB 66, and operate as a manifold to bring fluid to and from said plurality of circuit substrates 12, 12'.

. Figure 3A illustrates a cross section along a horizontal plane A-A' (shown in Figure 3) of a circuit substrate 12' that is similar to circuit substrate 12, showing the microchannels 88 as well as their microchannel inputs 90 and microchannel outputs 92. Substrates 12' and 12 are similar layers, but their layout does not need to be the same as they may for example not have identical circuits 14.

. Figure 3B illustrates a partial cross section along a horizontal plane B-B' (shown in Figure 3) of circuit substrate 12', showing the portions of cavities 82 and 86 that form input manifold 96 and communicate with output manifold 98.

. Figure 3C illustrates a partial cross section along a horizontal plane C-C' (shown in Figure 3) of circuit substrate 12', showing cavities 30, 86 with their walls formed in part by cold weld compression seals 34 and 102. It is noted that the single, large, cavities 30, 86 illustrated in Fig. 3C can be replaced by a plurality of smaller cavitied 30, 86 surrounded each by a smaller compression seals 34, 102.

. Figure 4A illustrates a cross section of an electronic assembly 110 according to embodiments of this presentation, which is similar to the assembly 80 illustrated in Fig. 3 but differs in that circuit substrate 12 comprises a single layer/chip wherein both circuit 14 and cavity 82 are formed. Another difference is that in fluid path substrate 18, the fluid path 20 forms at least a portion of a loop heat pipe. Fluid path 20 can then comprise a liquid chamber 112 fluidly connected upstream of the first cavity 30 via fluid path input 24, and a condensation chamber 114 fluidly connected to the first cavity 30 downstream of the fluid path output 26; the condensation chamber 114 itself in fluid communication with the further downstream liquid chamber 112. First cavity 30 of this embodiment is similar to the first cavity 30 of Fig. 3, but comprises an evaporator region 89 filled with porous material (which can be made of the microchannels 88 of Fig. 3 or can comprise a different porous structure). According to embodiments of this presentation, condensation chamber 114 is thermally coupled with a heat exchange structure 116 (e.g. a radiator, a transient heat storage structure; a phase change material). It is to be noted that the heat exchange structure is in practice much larger than in the schematic depiction of Figure 4A. According to embodiments of this presentation, the first cavity 30, condensation chamber 114 and liquid chamber 112 are arranged such that: when the integrated circuit 14 generates heat, the heat causes a portion of the cooling fluid, that has passed into the first cavity 30 and into circuit substrate cavity 82 from the liquid chamber 112, to evaporate and move to the condensation chamber 114, where the evaporated fluid is condensed by heat exchange with the heat exchange structure 116 and the liquefied fluid enters back the liquid chamber 112. The heat can alternatively make the fluid in the fluid path less dense but without changing the phase of the fluid, instead of causing the fluid to become gaseous. Generally, the heat from the integrated circuit evaporates the cooling fluid without substantially warming it. Essentially, the heat generated by the circuit 14 is captured by the fluid when the heat makes the liquid fluid gaseous in circuit substrate cavity 82, and the liquefaction of the gaseous fluid in condensation chamber 114 gives back the heat that is then evacuated using heat exchange structure 116. Preferably, a wicking structure (not shown) is provided to bring back the condensed fluid from the condensation chamber 114 to the evaporator region 89.

. Figure 4B illustrates a cross section of an electronic assembly 110' according to other embodiments of this presentation, which is similar to the assembly 110 illustrated in Fig. 4A, but differs in that the fluid path forms a standard heat pipe rather than a loop heat pipe as in Figure 4A. The standard heat pipe essentially comprises, for each substrate 12, at least one fluid path 20 (including condensation chamber 114, an intermediate cavity 30 and a circuit substrate cavity 82) lined with a wicking material / porous lining 91 (the cavity can be fully lined or partially lined, as long as there exists a continuous lining path from 82 to 30 to 114). The heat produced by the integrated circuit 14 evaporates the fluid in circuit substrate cavity 82. The pressure of the evaporation process pushes the evaporated fluid into liquid chamber 112 then to condensation chamber 114, where it condenses and is captured by the porous lining 91 that brings back the liquid fluid to circuit substrate cavity 82. According to embodiments of this presentation, the porous lining 91 in cavity 30 can be formed of upper and lower parts (E.g. two concentric parts) that imbricate or otherwise contact to form a continuous porous pathway when the cold weld compression seal 34 is formed. According to embodiments of this presentation, porous lining 91 can comprise sintered powder, partially fused powder (e.g. ALD coated powder), grooves (e.g. etched), roughened surface (E.g. XeF2 etched), porous metallic deposit (e.g. electroless metal deposition), electrochemical dealloying, metal assisted chemical etching, etched pillar arrays, nanowire or nanotube growth, microwire or microtube growth, etc..

. Figure 4C illustrates a cross section of an electronic assembly 110" according to other embodiments of this presentation, which is similar to the assembly 110 illustrated in Fig. 4A, but differs in that the fluid path 20 is arranged to form a thermosiphon, i.e. the fluid path does not form a loop as in Figure 4A, which may comprise a wick structure to bring back condensed fluid by capillary action, in the embodiment of Figure 4C, the liquid fluid formed by condensation in condensation chamber 114 fluid is brought down to circuit substrate cavity 82 by gravity. Circuit substrate cavity 82 can comprise a porous structure, such as a microchannel structure 88, to help the liquid fluid circulate and capture a maximum of the heat generated by integrated circuit 14.

. It is to be noted that any of the fluid path 20 illustrated can have a portion outside of the heat removal substrate (such as illustrated in Figure 1)..

. Figure 5 illustrates a cross section of an electronic assembly 120 according to embodiments of this presentation, which is similar to the assembly 80 illustrated in Fig. 3 but differs in that the circuit substrate 12, instead of being formed of a first circuit substrate layer 104 that comprises integrated circuit 14 but no portion of the fluid path 20 and a second circuit substrate layer 106 that comprises no integrated circuit but does comprise a portion of the fluid path 20, is now formed of a first circuit substrate layer 122 that comprises integrated circuit 14 and a portion of the fluid path 20 (comprising the microchannels 88, the microchannel inputs 90 and microchannel outputs 92) and a second circuit substrate layer 124 that comprises no integrated circuit, but another portion of the fluid path 20 (including circuit substrate cavity input 84, input manifold 82 + 96, circuit substrate cavity output 86 and output manifold 98). In such an embodiment, the first circuit substrate layer 122 is attached to the second circuit substrate layer 124 by a first cold weld compression seal 126 that sealingly attaches microchannel inputs 90 to input manifold 96 and a second cold weld compression seal 128 that sealingly attaches microchannel outputs 92 to output manifold 98. It will be appreciated that a circuit substrate 12 according to the embodiment of Figure 5 can be easier to manufacture than for example the circuit substrate 12 according to the embodiment of Figure 3, by allowing to manufacture separately the portions of the path in substrate layers 122 and 124.

. Figure 5A illustrates a cross section along a horizontal plane A-A' (shown in Figure 5) of a circuit substrate 12' identical to circuit substrate 12, showing the microchannels 88 as well as their microchannel inputs 90 and microchannel outputs 92.

. Figure 5B illustrates a partial cross section along a horizontal plane B-B' (shown in Figure 5) of circuit substrate 12', showing the portions of cavities 82 and 86 that form input manifold 96 / communicate with output manifold 98.

. Figure 5C illustrates a partial cross section along a horizontal plane C-C' (shown in Figure 5) of circuit substrate 12', showing cavities 30, 86 with their walls formed in part by cold weld compression seals 34 and 102. It is noted that the single, large, cavities 30, 86 illustrated in Fig. 5C can be replaced by a plurality of smaller cavitied 30, 86 surrounded each by a smaller compression seals 34, 102.

. Figure 5D illustrates a partial cross section along a horizontal plane D-D' (shown in Figure 5) of circuit substrate 12', showing compression seals 126, 128. The figure also shows an optional periphery seal 129 that can be arranged on a periphery of substrate layer 122 for added seal strength.

. Figure 6 illustrates a cross section of an electronic assembly 130 according to embodiments of this presentation, which is similar to the assembly 80 illustrated in Fig. 3, but differs in that the circuit substrate 12, instead of being directly attached to the interposer 68 and the PCB 66, is attached to a stack of circuit substrates 132 comprising at least one additional circuit substrate 12". The stack 132 can be attached to the interposer 68 and PCB 66. In this embodiment, circuit substrate 12 can comprise a fluid output 134 and a fluid input 136 that are fluidly connected respectively to a fluid input 138 of the stack 132 and a fluid output 140 of the stack 132, respectively using a cold weld compression seal 142 and a cold weld compression seal 144. According to embodiments of this presentation, the at least one additional circuit substrate 12" can have a structure similar to the structure of circuit substrate 12, and include an integrated circuit 14" as well as a cavity 82" that communicates with fluid input 138 and fluid output 140 and forms a part of fluid path 20, the cavity 82" being arranged such that fluid traversing the cavity absorbs heat produced by integrated circuit 14". According to embodiments of this presentation, cavity 82" can comprise microchannels 88" arranged between input and output manifolds themselves fluidly coupled to fluid input 138 and fluid output 140. All of the circuit substrates of stack 132 can advantageously be fluidly connected together using cold weld compression seals such as detailed previously. Such embodiments allow integrating compactly a plurality of circuit substrates in a way that allows to cool them down all using a single fluid pump. In Fig. 6, the stack 132 is shown comprising a plurality of circuit substrates 12, 12" similar to the circuit substrate 12 of Fig. 4, but any circuit substrate disclosed in this presentation can be used in replacement of circuit substrates 12, 12" of Fig. 6. As a variation (not illustrated), some of the chips in the stack may only have fluid inlets and outlets (no lateral microchannels 88"). It is to be noted that the chips or substrates in adjacent stacks do not need to be the same number or height. It is also to be noted that any of the embodiments illustrated above can be made into a multichip stack as illustrated in Fig 6. Also, more than one of the embodiments illustrated above (pumped microchannel cooling, jet impingement, etc...) can be integrated into a single assembly (as separate loops).

. As outlined in the previous figures, the heat removal substrate 18 can act as a manifold and can be fluidly connected to at least two circuit substrates 12, 12', to evacuate heat from each of the circuit substrates using the fluid flow in the fluid path 20. As illustrated in Fig. 6, each of the at least two circuit substrates 12, 12' can be fluidly connected to a vertical stack 132, 132' of circuit substrates.

. Figure 7 illustrates a cross section of an electronic assembly 140 according to embodiments of this presentation, which is similar to the assembly 80 illustrated in Fig. 3 but differs in that at least one via 162 traverses vertically the heat removal substrate 18, which is aligned with a via 164 that traverses vertically circuit substrate 12 where via 162 is electrically connected to via 164 using a cold weld connection 146. According to embodiments of this presentation, lateral routing (not illustrated) can be added to vias 162 and/or 164. Cold weld connection 146 can comprise a cone or pyramid 148 (or a peaked ridge, or an array of any of these features) of a harder material, for example a harder metal, such as titanium, coated with a thin layer of a softer metal, such as gold (or copper, indium or aluminum), before being pressed into a pad 150 formed of a thicker layer of the softer metal or another softer metal, for example gold (or copper, indium or aluminum). In some embodiments, the cold weld connection can comprise only two protrusions of a soft metal that are pressed into each other to form a permanent electrical contact. Alternatively, the cold weld connection 146 can comprise two peaked ridges (or arrays of ridges) pressed into each other (e.g. at a 90 degree angle). Cold weld connection 146 has essentially the same structure as cold weld seal 34 as detailed above, but arranged to make an electrical connection between two vias rather than a seal along a closed boundary. Cold weld connection 146 is provided for being formed at the same time the cold weld seals 34 and 102 are formed. Via 164 can be electrically connected to integrated circuit 14. An electrical contact pad 152 can be formed on a top surface of heat removal substrate 18 for easy connection to control electronics.

. Figure 8 illustrates a cross section of an electronic assembly 160 according to embodiments of this presentation which is similar to the assembly 130 illustrated in Fig. 6, but differs in that the circuit substrates 12", etc... of circuit substrate stack 132 are all traversed by vias 164 connected electrically to their integrated circuits 14", etc... The vias are interconnected using cold weld connections 146" which can be identical to the connection 146 described above and that are arranged between the circuit substrates. It is to be noted that that the vias do not need to traverse all of the chips / substrates in the stack. Some vias may traverse a single chip / substrate and terminate with a single cold weld to another chip / substrate. Some may traverse two chips and have two cold welds, etc...

. Figure 9 illustrates an electronic assembly 170 according to embodiments of this presentation where the fluid path 20 is arranged for operating as an oscillating heat pipe. Fluid path 20 comprises a plurality of vertical cavities 172 and horizontal cavities 174 formed in heat removal substrate 18, as well as horizontal cavities formed in the circuit substrate 12, which are all connected together using cold weld compression seals 34 between substrate 18 and substrate 12. In such embodiment, the heat from the integrated circuit 14 of substrate 12 causes an evaporation of the liquid fluid into vapor bubbles; this increases the local pressure in the cavities 176 close to circuit 14 due to the expansion of vapor bubbles and the pressure increase pushes the vapor bubbles toward the cavities 174, which act as condensation chambers. The movement is not steady but pulsating due to the random distribution of the vapor bubbles, as well as pressure imbalances across the tube. The fluid path 20 is arranged such that capillary forces within the path help maintain a slug-bubble structure, preventing the fluid from pooling. In the condensation chambers 174, the vapor bubbles condense back into liquid as they lose heat to the surroundings, for example via a heat exchange structure on top of substrate 18 (not shown).

. Figure 9A illustrates a cross section of the embodiment of Figure 9 along the plane A-A' shown on Figure 9.

. Having now described the invention in accordance with the requirements of the patent statutes, those skilled in this art will understand how to make changes and modifications to the present invention to meet their specific requirements or conditions. Such changes and modifications may be made without departing from the scope and spirit of the invention as disclosed herein.

. The foregoing Detailed Description of exemplary and preferred embodiments is presented for purposes of illustration and disclosure in accordance with the requirements of the law. It is not intended to be exhaustive nor to limit the invention to the precise form(s) described, but only to enable others skilled in the art to understand how the invention may be suited for a particular use or implementation. The possibility of modifications and variations will be apparent to practitioners skilled in the art. No limitation is intended by the description of exemplary embodiments which may have included tolerances, feature dimensions, specific operating conditions, engineering specifications, or the like, and which may vary between implementations or with changes to the state of the art, and no limitation should be implied therefrom.

. Applicant has made this disclosure with respect to the current state of the art, but also contemplates advancements and that adaptations in the future may take into consideration of those advancements, namely in accordance with the then current state of the art. It is intended that the scope of the invention be defined by the Claims as written and equivalents as applicable. Reference to a claim element in the singular is not intended to mean "one and only one" unless explicitly so stated. Moreover, no element, component, nor method or process step in this disclosure is intended to be dedicated to the public regardless of whether the element, component, or step is explicitly recited in the Claims. No claim element herein is to be construed under the provisions of 35 U.S.C. Sec. 112(f), unless the element is expressly recited using the phrase "means for. . ." and no method or process step herein is to be construed under those provisions unless the step, or steps, are expressly recited using the phrase "comprising the step (s) of .... "

. All elements, parts and steps described herein are preferably included. It is to be understood that any of these elements, parts and steps may be replaced by other elements, parts and steps or deleted altogether as will be obvious to those skilled in the art.

## Claims

1. An electronic assembly comprising:
a circuit substrate comprising an integrated circuit, the circuit substrate having a first surface; and
a heat removal substrate comprising a fluid path arranged for circulating a flow of cooling fluid between a fluid path input and a fluid path output, the heat removal substrate having a second surface attached to the first surface, wherein
the fluid path includes a first cavity having cavity walls, wherein a first portion of the cavity walls comprises a first portion of the first surface and a second portion of the cavity walls comprises a first portion of the second surface; and wherein
the second surface is attached to the first surface by at least a first cold weld compression seal that sealingly attaches the first portion of the first surface to the first portion of the second surface along a first closed boundary; said compression seal along that first closed boundary forming a third portion of the cavity walls.

2. The electronic assembly of claim 1, wherein the fluid path comprises a circuit substrate cavity, the circuit substrate cavity being in the circuit substrate and having at least one circuit substrate cavity input and at least one circuit substrate cavity output, where the at least one circuit substrate cavity input comprises a first fluid path opening in said first portion of the first surface within said first closed boundary.

3. The electronic assembly of claim 1, wherein the heat removal substrate comprises a first heat removal substrate layer assembled to a second heat removal substrate layer by a second cold weld compression seal; said fluid path comprising a second cavity having a first portion of the second cavity in the first heat removal substrate layer and having a second portion of the second cavity in the second heat removal substrate layer; the first portion of the second cavity being sealed in fluid communication with the second portion of the second cavity by the second cold weld compression seal.

4. The electronic assembly of claim 1, wherein the fluid path comprises a colder fluid chamber; the colder fluid chamber being separated from the first cavity by at least one jet opening; wherein said at least one jet opening is arranged for constricting the flow of cooling fluid between the colder fluid chamber and the first cavity.

5. The electronic assembly of claim 4, wherein the at least one jet opening comprises a plurality of jet openings having each an axis directed at a predetermined region of said first portion of the first surface, to controllably cool down said predetermined regions of said first portion of the first surface; or wherein the colder fluid chamber is arranged to receive the flow of cooling fluid from the fluid path input and wherein the fluid path is arranged such that the flow of cooling fluid entering the first cavity by the at least one jet opening exits from the first cavity toward the fluid path output.

6. The electronic assembly of claim 1, wherein the fluid path comprises a colder fluid chamber fluidly connected to the first cavity upstream of said fluid path input; and a cooling chamber fluidly connected to the first cavity downstream of the fluid path output; the cooling chamber being in fluid communication with the further downstream colder fluid chamber; the cooling chamber being thermally coupled with a heat exchange structure; the first cavity, cooling chamber and colder fluid chamber being arranged such that: when said integrated circuit generates heat, the heat causes a portion of the cooling fluid, that has passed into the first cavity from the colder fluid chamber, to warm up and enter the cooling chamber where the fluid is cooled down by heat exchange with the heat exchange structure and the cooled fluid enters back the colder fluid chamber.

7. The electronic assembly of claim 1, wherein the fluid path forms at least a portion of one of a thermosiphon or a heat pipe.

8. The electronic assembly of claim 7, wherein the fluid path forms at least a portion of a heat pipe, and wherein the fluid path has walls covered with a wicking material arranged to bring condensed fluid from a condensation cavity to a portion of the first cavity that receives heat produced by the integrated circuit.

9. The electronic assembly of claim 2, wherein said circuit substrate additionally comprises a circuit substrate fluid output in fluid communication with the at least one circuit substrate cavity input and a circuit substrate fluid input in fluid communication with the at least one circuit substrate cavity output, the electronic assembly further comprising a circuit substrate stack having a stack fluid output and a stack fluid input; the stack fluid input being sealingly connected to the circuit substrate fluid output using a second cold weld compression seal and the stack fluid output being sealingly connected to the circuit substrate fluid input using a third cold weld compression seal; the circuit substrate stack comprising at least one additional circuit substrate having an additional integrated circuit, and being arranged such that fluid circulated in the fluid path captures heat produced by the additional integrated circuit.

10. The electronic assembly of claim 1, wherein the circuit substrate comprises a first via electrically connected to a first electrical contact pad on said first surface, and the heat removal substrate comprises a second via electrically connected to a second electrical contact pad on said second surface; the first and second electrical contact pad being aligned and being electrically connected using a cold weld compression contact structure.

11. The electronic assembly of claim 2, wherein at least a portion of the circuit substrate cavity comprises microchannels that facilitate heat transfer between said cooling fluid and said circuit substrate, the microchannels having microchannel inputs and microchannel outputs wherein the microchannel inputs are in fluid communication with the at least one circuit substrate cavity input through an input manifold, and wherein the microchannel outputs are in fluid communication with the at least one circuit substrate cavity output through an output manifold.

12. The electronic assembly of claim 11, wherein the input manifold forms part of the circuit substrate cavity and is in fluid communication with the first cavity and wherein the output manifold is in fluid communication with the fluid path output through an exhaust cavity; wherein the exhaust cavity is sealingly connected to said at least one circuit substrate cavity output using a second cold weld compression seal formed along a second closed boundary.

13. The electronic assembly of claim 12, wherein the circuit substrate comprises a first circuit substrate layer attached to a second circuit substrate layer; wherein the first circuit substrate layer comprises said integrated circuit, said microchannels, said microchannel inputs and said microchannel outputs; and wherein the second circuit substrate layer comprises said at least one circuit substrate cavity input, said input manifold, said at least one circuit substrate cavity output and said output manifold; the first circuit substrate layer being attached to a second circuit substrate layer by a third cold weld compression seal sealingly coupling said microchannel inputs to said input manifold and by a fourth cold weld compression seal sealingly coupling said microchannel outputs to said output manifold.

14. The electronic assembly of claim 1, wherein the cold weld compression seal comprises a knife-edge wall of a harder material having a foot attached to one of the first and second surfaces along said first closed boundary, said knife-edge wall being coated with a softer metal before being pressed on a seal strip of another softer metal attached to the other of the first and second surfaces along said first closed boundary.

15. The electronic assembly of claim 2, wherein said circuit substrate comprising an integrated circuit includes a first sub-substrate comprising a first integrated circuit portion and includes a second sub-substrate comprising the circuit substrate cavity, wherein the first sub-substrate has a first sub-surface attached to a second sub-surface of the second sub-substrate.
